# EUROPEAN PATENT APPLICATION

(11) **EP 1 482 371 A1**
(43) Date of publication of application: **01.12.2004**
(21) Application number: 04252969.3
(22) Date of filing: 20.05.2004
(51) Int. Cl.: G03F 7/20

(54) **Method of calibrating a lithographic apparatus**

(30) Priority: 28.05.2003 EP 03253333
(71) Applicant: ASML Netherlands B.V., 5504 DR Veldhoven (NL)
(72) Inventor: Baselmans, Johannes Jacobus Matheus, 5688 GG Oirschot (NL); Bleeker, Arno Jan, 5563 CE Westerhoven (NL)
(74) Representative: Leeming, John Gerard

(57) **Abstract**

To calibrate a lithographic apparatus having a programmable patterning means, a sensor, such as a CCD, CMOS sensor or photo-diode array, having detector elements larger than the size of a spot corresponding to a single pixel of the programmable patterning means is used. Pixels are selectively activated singly or in groups.

## Description

The present invention relates to a lithographic apparatus and a device manufacturing method.

A lithographic apparatus is a machine that applies a desired pattern onto a target portion of a substrate. Lithographic apparatus can be used, for example, in the manufacture of integrated circuits (ICs), flat panel displays and other devices involving fine structures. In a conventional lithographic apparatus, a patterning means, which is alternatively referred to as a mask or a reticle, may be used to generate a circuit pattern corresponding to an individual layer of the IC (or other device), and this pattern can be imaged onto a target portion (e.g. comprising part of, one or several dies) on a substrate (e.g. a silicon wafer or glass plate) that has a layer of radiation-sensitive material (resist). Instead of a mask, the patterning means may comprise an array of individually controllable elements which serve to generate the circuit pattern.

In general, a single substrate will contain a network of adjacent target portions that are successively exposed. Known lithographic apparatus include so-called steppers, in which each target portion is irradiated by exposing an entire pattern onto the target portion in one go, and so-called scanners, in which each target portion is irradiated by scanning the pattern through the projection beam in a given direction (the "scanning"-direction) while synchronously scanning the substrate parallel or anti-parallel to this direction.

In a lithographic apparatus using a programmable patterning means, several additional calibrations, as compared to a machine using a conventional mask, must be carried out. For example, it is necessary to measure the intensity of the radiation delivered to the substrate for each element (pixel) of the programmable patterning means. The size and position of each spot projected onto the substrate must also measured. Given the very large number of elements in a programmable patterning means, potentially tens of millions, such pixel-by-pixel calibrations take an excessive length of time and represent a substantial reduction in throughput if it is necessary to repeat them periodically.

In a lithographic apparatus for forming very fine patterns, particularly one employing a reducing projection system, the calibration is also very difficult as the spot projected onto the substrate for each pixel is extremely small - much smaller than any detector, even the individual elements of a CCD. It should be noted that the spot size on the substrate is determined by the projection optics and may be larger than the geometric image of a single pixel of the programmable patterning means, depending on the value of the k1 factor. Carrying out a series of test exposures and measuring the results can be done but is very time consuming and hence impracticable for periodic recalibration. It has therefore been proposed to carry out calibration measurements at an intermediate image plane of the projection lens, e.g. by providing a semi-transparent mirror to direct a portion of the beam to a detector, see for example US2003/0081303 Al and WO 03/046665, or by providing a detector that can be moved into and out of the beam. An intermediate image plane where the image is much larger than that projected onto the substrate can be chosen. However, a semi-transparent mirror will inevitably degrade the projected image to some extent and providing the space and mechanism for a moveable detector in the projection lens may not be convenient. Also, measurements at an intermediate image plane cannot take account of the effects of subsequent elements of the projection lens.

US 6,121,626 and US 2001/0033996A disclose lithographic apparatus using a transmissive dynamic mask and a CCD mounted on the wafer stage. The CCD image is compared to the desired image to optimize the pattern on the dynamic mask as well as focus, dose, NA and σ settings.

It is an object of the present invention to provide apparatus and methods to enable more rapid and reliable calibration of a programmable patterning means, preferably using measurements made at substrate level.

This and other objects are achieved according to the invention in a lithographic apparatus comprising:
- an illumination system for supplying a projection beam of radiation;
- an array of individually controllable elements serving to impart the projection beam with a pattern;
- a substrate table for supporting a substrate; and
- a projection system for projecting the patterned beam onto a target portion of the substrate,
characterized by:
- a detector positionable in the projected patterned beam in place of said substrate and having a plurality of detector elements, each detector element being larger than a spot corresponding to a single pixel of said programmable patterning means.

Appropriate selective activation of the elements (pixels) of the array enables use of a detector having detector elements much larger than the spots projected corresponding to each pixel. The pixels may be activated singly or in patterns to calibrate them individually or to detect changes. Between successive activation and detection cycles, the detector can be moved, either to enable a smaller detector to be used to calibrate a larger array or to improve calibration of pixels on or near the borders between detector elements.

Preferably, the detector is mounted on the substrate table enabling it to be positioned in the projection beam with the already existing positioning system for the substrate table.

Preferably, the detector comprises a CCD, a CMOS sensor or a photo-diode array.

In a preferred embodiment, the detector further comprises an aperture member having a plurality of apertures corresponding to the plurality of detector elements, each aperture being larger than the spot projected onto said detector and corresponding to a single pixel. Preferably, each aperture is larger than ten times the size of the projected spot and/or smaller than 75% of the size of a detector element. The aperture member enables crosstalk between pixels to be reduced.

It is also preferred that the detector further comprises a microlens array, each microlens of said microlens array serving to spread the radiation corresponding to a single pixel across one or more of said detector elements. The microlens array enables the sensitivity of measurements to be increased.

According to a further aspect of the invention there is provided:
a device manufacturing method comprising the steps of:
   - providing a substrate;
   - providing a projection beam of radiation using an illumination system;
   - an array of individually controllable elements to impart a pattern to the projection beam; and
   - projecting the patterned beam of radiation onto a target portion of the substrate;
characterized in that prior to said step of using array of individually controllable elements, said array is calibrated by a method according to any one of claims 6 to 11 as described above.

The term "array of individually controllable elements" as here employed should be broadly interpreted as referring to any means that can be used to endow an incoming radiation beam with a patterned cross-section, so that a desired pattern can be created in a target portion of the substrate; the terms "light valve" and "Spatial Light Modulator" (SLM) can also be used in this context. Examples of such patterning means include:
- A programmable mirror array. This may comprise a matrix-addressable surface having a viscoelastic control layer and a reflective surface. The basic principle behind such an apparatus is that (for example) addressed areas of the reflective surface reflect incident light as diffracted light, whereas unaddressed areas reflect incident light as undiffracted light. Using an appropriate spatial filter, the said undiffracted light can be filtered out of the reflected beam, leaving only the diffracted light to reach the substrate; in this manner, the beam becomes patterned according to the addressing pattern of the matrix-addressable surface. It will be appreciated that, as an alternative, the filter may filter out the diffracted light, leaving the undiffracted light to reach the substrate. An array of diffractive optical MEMS devices can also be used in a corresponding manner. Each diffractive optical MEMS device is comprised of a plurality of reflective ribbons that can be deformed relative to one another to form a grating that reflects incident light as diffracted light. A further alternative embodiment of a programmable mirror array employs a matrix arrangement of tiny mirrors, each of which can be individually tilted about an axis by applying a suitable localized electric field, or by employing piezoelectric actuation means. Once again, the mirrors are matrix-addressable, such that addressed mirrors will reflect an incoming radiation beam in a different direction to unaddressed mirrors; in this manner, the reflected beam is patterned according to the addressing pattern of the matrix-addressable mirrors. The required matrix addressing can be performed using suitable electronic means. In both of the situations described hereabove, the array of individually controllable elements can comprise one or more programmable mirror arrays. More information on mirror arrays as here referred to can be gleaned, for example, from United States Patents US 5,296,891 and US 5,523,193, and PCT patent applications WO 98/38597 and WO 98/33096, which are incorporated herein by reference.
- A programmable LCD array. An example of such a construction is given in United States Patent US 5,229,872, which is incorporated herein by reference.

It should be appreciated that where pre-biasing of features, optical proximity correction features, phase variation techniques and multiple exposure techniques are used, for example, the pattern "displayed" on the array of individually controllable elements may differ substantially from the pattern eventually transferred to a layer of or on the substrate. Similarly, the pattern eventually generated on the substrate may not correspond to the pattern formed at any one instant on the array of individually controllable elements. This may be the case in an arrangement in which the eventual pattern formed on each part of the substrate is built up over a given period of time or a given number of exposures during which the pattern on the array of individually controllable elements and/or the relative position of the substrate changes.

Although specific reference may be made in this text to the use of lithographic apparatus in the manufacture of ICs, it should be understood that the lithographic apparatus described herein may have other applications, such as the manufacture of integrated optical systems, guidance and detection patterns for magnetic domain memories, flat panel displays, thin-film magnetic heads, etc. The skilled artisan will appreciate that, in the context of such alternative applications, any use of the terms "wafer" or "die" herein may be considered as synonymous with the more general terms "substrate" or "target portion", respectively. The substrate referred to herein may be processed, before or after exposure, in for example a track (a tool that typically applies a layer of resist to a substrate and develops the exposed resist) or a metrology or inspection tool. Where applicable, the disclosure herein may be applied to such and other substrate processing tools. Further, the substrate may be processed more than once, for example in order to create a multi-layer IC, so that the term substrate used herein may also refer to a substrate that already contains multiple processed layers.

The terms "radiation" and "beam" used herein encompass all types of electromagnetic radiation, including ultraviolet (UV) radiation (e.g. having a wavelength of 408, 355, 365, 248, 193, 157 or 126 nm) and extreme ultra-violet (EUV) radiation (e.g. having a wavelength in the range of 5-20 nm), as well as particle beams, such as ion beams or electron beams.

The term "projection system" used herein should be broadly interpreted as encompassing various types of projection system, including refractive optical systems, reflective optical systems, and catadioptric optical systems, as appropriate for example for the exposure radiation being used, or for other factors such as the use of an immersion fluid or the use of a vacuum. Any use of the term "lens" herein may be considered as synonymous with the more general term "projection system".

The illumination system may also encompass various types of optical components, including refractive, reflective, and catadioptric optical components for directing, shaping, or controlling the projection beam of radiation, and such components may also be referred to below, collectively or singularly, as a "lens".

The lithographic apparatus may be of a type having two (dual stage) or more substrate tables. In such "multiple stage" machines the additional tables may be used in parallel, or preparatory steps may be carried out on one or more tables while one or more other tables are being used for exposure.

The lithographic apparatus may also be of a type wherein the substrate is immersed in a liquid having a relatively high refractive index, e.g. water, so as to fill a space between the final element of the projection system and the substrate. Immersion liquids may also be applied to other spaces in the lithographic apparatus, for example, between the array of individually controllable elements and the first element of the projection system. Immersion techniques are well known in the art for increasing the numerical aperture of projection systems.

Exemplary embodiments of the invention will now be described, by way of example only, with reference to the accompanying schematic drawings, in which:
Figure 1 depicts a lithographic projection apparatus according to a first embodiment of the invention;
Figure 2 depicts the substrate table, including the calibration detector;
Figure 3 illustrates the relationship between projected sports and detector elements; and
Figures 4 to 6 illustrate detectors used in second and third embodiments of the invention.

In the Figures, corresponding reference symbols indicate corresponding parts.

### Embodiment 1

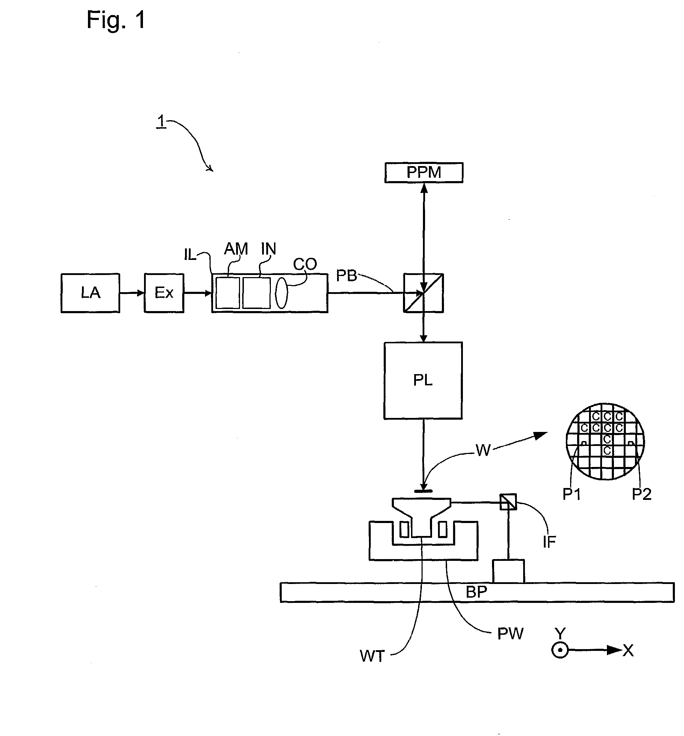

Figure 1 schematically depicts a lithographic projection apparatus according to a particular embodiment of the invention. The apparatus comprises:
- an illumination system (illuminator) IL for providing a projection beam PB of radiation (e.g. UV radiation);
- an array of individually controllable elements PPM (e.g. a programmable mirror array) for applying a pattern to the projection beam; in general the position of the array of individually controllable elements will be fixed relative to item PL; however it may instead be connected to a positioning means for accurately positioning it with respect to item PL;
- a substrate table (e.g. a wafer table) WT for supporting a substrate (*e.g.* a resist-coated wafer) W, and connected to positioning means PW for accurately positioning the substrate with respect to item PL; and
- a projection system ("lens") PL for imaging a pattern imparted to the projection beam PB by the array of individually controllable elements PPM onto a target portion C (e.g. comprising one or more dies) of the substrate W; the projection system may image the array of individually controllable elements onto the substrate; alternatively, the projection system may image secondary sources for which the elements of the array of individually controllable elements act as shutters; the projection system may also comprise an array of focusing elements such as a micro lens array (known as an MLA) or a Fresnel lens array, *e.g.* to form the secondary sources and to image microspots onto the substrate.

As here depicted, the apparatus is of a reflective type (*i.e.* has a reflective array of individually controllable elements). However, in general, it may also be of a transmissive type, for example (*i.e*. with a transmissive array of individually controllable elements).

The illuminator IL receives a beam of radiation from a radiation source SO. The source and the lithographic apparatus may be separate entities, for example when the source is an excimer laser. In such cases, the source is not considered to form part of the lithographic apparatus and the radiation beam is passed from the source SO to the illuminator IL with the aid of a beam delivery system BD comprising for example suitable directing mirrors and/or a beam expander. In other cases the source may be integral part of the apparatus, for example when the source is a mercury lamp. The source SO and the illuminator IL, together with the beam delivery system BD if required, may be referred to as a radiation system.

The illuminator IL may comprise adjusting means AM for adjusting the angular intensity distribution of the beam. Generally, at least the outer and/or inner radial extent (commonly referred to as σ-outer and σ-inner, respectively) of the intensity distribution in a pupil plane of the illuminator can be adjusted. In addition, the illuminator IL generally comprises various other components, such as an integrator IN and a condenser CO. The illuminator provides a conditioned beam of radiation, referred to as the projection beam PB, having a desired uniformity and intensity distribution in its cross-section.

The beam PB subsequently intercepts the array of individually controllable elements PPM. Having been reflected by the array of individually controllable elements PPM, the beam PB passes through the projection system PL, which focuses the beam PB onto a target portion C of the substrate W. With the aid of the positioning means PW (and interferometric measuring means IF), the substrate table WT can be moved accurately, *e.g.* so as to position different target portions C in the path of the beam PB. Where used, the positioning means for the array of individually controllable elements can be used to accurately correct the position of the array of individually controllable elements PPM with respect to the path of the beam PB, e.g. during a scan. In general, movement of the object table WT is realized with the aid of a long-stroke module (course positioning) and a short-stroke module (fine positioning), which are not explicitly depicted in Figure 1. A similar system may also be used to position the array of individually controllable elements. It will be appreciated that the projection beam may alternatively/additionally be moveable while the object table and/or the array of individually controllable elements may have a fixed position to provide the required relative movement. As a further alternative, that may be especially applicable in the manufacture of flat panel displays, the position of the substrate table and the projection system may be fixed and the substrate may be arranged to be moved relative to the substrate table. For example, the substrate table may be provided with a system for scanning the substrate across it at a substantially constant velocity.

Although the lithography apparatus according to the invention is herein described as being for exposing a resist on a substrate, it will be appreciated that the invention is not limited to this use and the apparatus may be used to project a patterned projection beam for use in resistless lithography.

The depicted apparatus can be used in four preferred modes:
1. Step mode: the array of individually controllable elements imparts an entire pattern to the projection beam, which is projected onto a target portion C in one go (i.e. a single static exposure). The substrate table WT is then shifted in the X and/or Y direction so that a different target portion C can be exposed. In step mode, the maximum size of the exposure field limits the size of the target portion C imaged in a single static exposure.
2. Scan mode: the array of individually controllable elements is movable in a given direction (the so-called "scan direction", e.g. the Y direction) with a speed v, so that the projection beam PB is caused to scan over the array of individually controllable elements; concurrently, the substrate table WT is simultaneously moved in the same or opposite direction at a speed V = Mv, in which M is the magnification of the lens PL. In scan mode, the maximum size of the exposure field limits the width (in the non-scanning direction) of the target portion in a single dynamic exposure, whereas the length of the scanning motion determines the height (in the scanning direction) of the target portion.
3. Pulse mode: the array of individually controllable elements is kept essentially stationary and the entire pattern is projected onto a target portion C of the substrate using a pulsed radiation source. The substrate table WT is moved with an essentially constant speed such that the projection beam PB is caused to scan a line across the substrate W. The pattern on the array of individually controllable elements is updated as required between pulses of the radiation system and the pulses are timed such that successive target portions C are exposed at the required locations on the substrate. Consequently, the projection beam can scan across the substrate W to expose the complete pattern for a strip of the substrate. The process is repeated until the complete substrate has been exposed line by line.
4. Continuous scan mode: essentially the same as pulse mode except that a substantially constant radiation source is used and the pattern on the array of individually controllable elements is updated as the projection beam scans across the substrate and exposes it.

Combinations and/or variations on the above described modes of use or entirely different modes of use may also be employed.

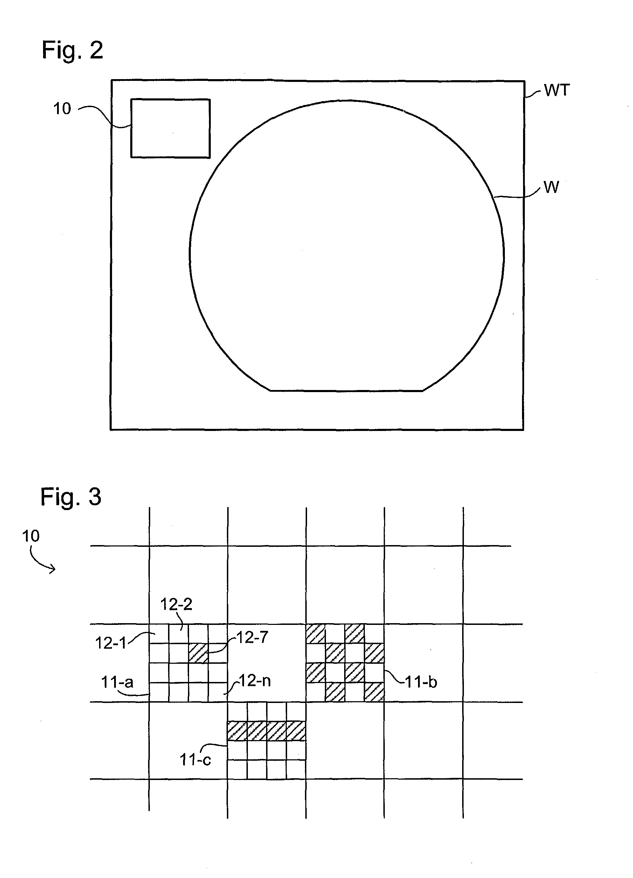

Figure 2 shows the substrate table WT carrying a substrate W mounted in a substrate holder (not shown) and a pixel calibration detector 10, which comprises an array of individual detecting elements 11. The pixel calibration detector may be a CCD, CMOS sensor, a photo-diode array or other suitable device. Where the radiation of the projection beam is at a wavelength, such as DUV, that would damage the detector, a conversion layer may be placed over the detector. The conversion layer converts, e.g. by fluorescence, the photons of the short wavelength exposure radiation to visible light which the detector can detect without suffering damage. As shown, the pixel calibration detector 10 is fixed to the substrate table WT adjacent the substrate holder but a removable detector, for example, mounted on a dummy substrate which can be held by the substrate holder, may also be employed. It is also possible to provide a separate positioning system to position the detector under the projection lens PL when required but it is preferable to make use of the substrate table, for which accurate positioning and displacement measuring systems are already provided. In a multiple stage apparatus, only one stage need be provided with a pixel calibration detector. The pixel calibration sensor may also be used to make other measurements outside the scope of the present invention and not further discussed herein.

Each detecting element 11 is larger than a spot projected onto the substrate corresponding to a single element of the array PPM, so that, as shown in Figure 3, an array of spots 12-1 to 12-n within each detecting element 11 can be separately irradiated by appropriate control of the corresponding pixels of the array PPM. According to a first method of the invention, a calibration is carried out by activating the pixels of the array PPM in sequence so that each detector element is only irradiated by one pixel at a time. The outputs of the elements of the detector are correlated to the sequence of activation of the pixels of the array PPM to provide a pixel-by-pixel intensity measurement which can be used for calibration. The detector does not need to be moved during the sequence of measurements so that the speed of the calibration is limited only by the switching speed of the programmable patterning means, which is fast, and the sensitivity and readout speed of the detector. Thus a suitably sensitive and fast sensor can enable a rapid calibration of the array.

After an initial calibration of the array, the pixel-by-pixel measurements can be stored as reference values to enable a more rapid detection of changes. In this second method of the invention, several pixels corresponding to each detector element 11 are activated at once and the resulting output is compared to the sum of the corresponding reference values. Any difference indicates that a change has occurred and a sequence of measurements can then be carried out to determine which of the pixels has been affected.

A preferred approach to identifying which of a group of pixels has caused a detected variation is to next activate a first half of the pixels in the group, e.g. as shown for detector element 11-b, and compare the output of the detector element to the summed corresponding reference values. If no change is detected in that step, the variation can be attributed to the second half of the original group whereas if a change accounting for the whole of the originally detected change is detected, the variation is attributed to the first half. Then, half of the half to which the change has been attributed is considered and so on until the change can be attributed to single pixels whose reference calibration values are amended accordingly. This method is akin to a binary tree search.

In the second method of the invention, two or more cycles may be carried out with the pixels differently grouped, e.g. by line as shown for detector element 11-c, to reduce the chance that variations in two or more pixels cancel each other out and hence go undetected.

### Embodiment 2

In a second embodiment of the invention, which is the same as the first embodiment save as described below, an aperture member is used to reduce crosstalk in the detector.

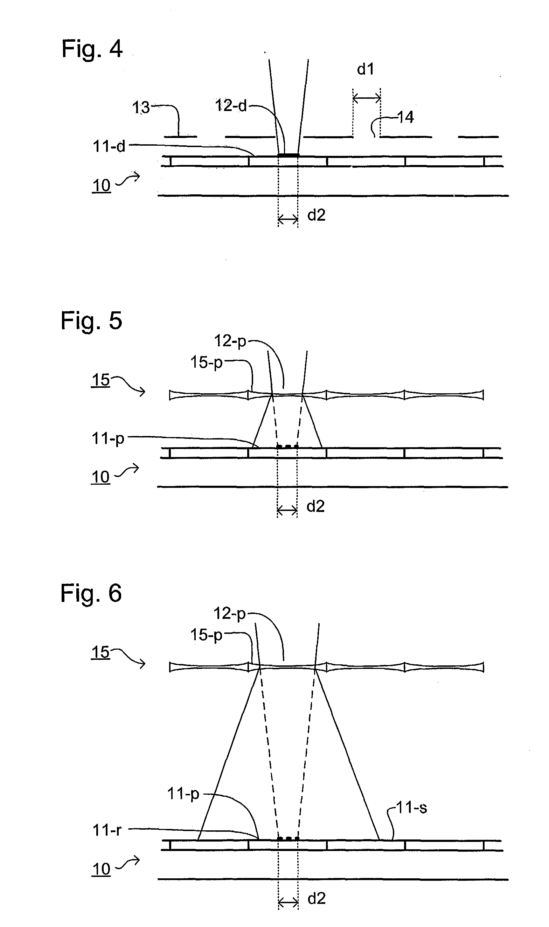

As shown in Figure 4, the aperture member 13 is located above the detector 10 and has one aperture 14 for each of the detector elements 11. Each aperture 14 is shaped and sized to ensure that all of the light directed to the substrate from one pixel of the array PPM reaches the detector but that as little other light as possible does. For example, if each pixel of the array creates a square spot on the substrate of side d2, each aperture 14 may also be square with side d1, where d1 > d2. The amount by which d1 is greater than d2 must be sufficient to encompass the possible variation in spot sizes.

The aperture member 14 may be a separate plate member or a layer deposited on the surface of detector 10. In either case, the aperture member should be a suitable material and of sufficient thickness to be effectively opaque to the radiation of the projection beam. The apertures 14 can be created with the required positioning and size accuracy by lithographic techniques, e.g. by using a high dose to expose a larger than normal region using a single pixel or by overetching.

When using a detector with an aperture member, the detector will need to be shifted to align the aperture with the spots projected from the different pixels to be calibrated but if the spacing of the apertures correctly matches the spacing of projected spots, the number of movements is only equal to the number of pixels in the array per detecting element and need not cause an undue increase in the length of time taken for the calibration.

With the aperture layer, only light from a selected pixel reaches the detector element 11 and so the effects of stray light, seriously misaligned pixels or pixels stuck in the "on" position can be eliminated.

### Embodiment 3

In a third embodiment, a microlens array is used to spread out the radiation from a selected pixel to improve the sensitivity of the sensor.

The microlens array 15 can be employed to spread the light across a single detector element 11-p, as shown in Figure 5, or across several elements 11-p to 11-s, as shown in Figure 6. By directing light more evenly across a detector element, localized damage to the detector is avoided and bloom, or local overloading of the detector, is reduced. Spreading the light across several detector cells can be useful where the intensity of a spot is high and risks overloading a single detector element. It also allows for longer "exposures" to increase sensitivity and can enable a measurement of the size and position of the spot by comparison of the intensities recorded by the several detector elements receiving light from the spot.

The microlens array may also be used in combination with an aperture member as used in the second embodiment. If the aperture member is a deposited layer, it may be provided on the microlens array 15 rather than the detector 10.

Whilst specific embodiments of the invention have been described above, it will be appreciated that the invention may be practiced otherwise than as described. The description is not intended to limit the invention.

## Claims

1. A lithographic apparatus comprising:
- an illumination system for supplying a projection beam of radiation;
- an array of individually controllable elements serving to impart the projection beam with a pattern;
- a substrate table for supporting a substrate; and
- a projection system for projecting the patterned beam onto a target portion of the substrate,
**characterized by**:
- a detector positionable in the projected patterned beam in place of said substrate and having a plurality of detector elements, each detector element being larger than a spot corresponding to a single pixel of said programmable patterning means.

2. Apparatus according to claim 1 wherein said detector is mounted on said substrate table.

3. Apparatus according to claim 1 or 2 wherein said detector comprises a CCD, a CMOS sensor or a photo-diode array.

4. Apparatus according to claim 1, 2 or 3 wherein said detector further comprises an aperture member having a plurality of apertures corresponding to the plurality of detector elements, each aperture being larger than the spot projected onto said detector and corresponding to a single pixel of said patterning means, each aperture preferably being larger than ten times the size of the projected spot and/or smaller than 75% of the size of a detector element.

5. Apparatus according to any one of the preceding claims wherein said detector further comprises a microlens array, each microlens of said microlens array serving to spread the radiation corresponding to a single element of said array across one or more of said detector elements.

6. A method of calibrating a lithographic apparatus comprising:
- an illumination system for providing a projection beam of radiation;
- an array of individually controllable elements serving to impart the projection beam with a pattern;
- a substrate table for supporting a substrate; and
- a projection system for projecting the patterned beam onto a target portion of the substrate,
the method comprising the steps of
- positioning a detector in the projected patterned beam in place of said substrate, said detector having a plurality of detector elements, each detector element being larger than a spot corresponding to a single element of said array;
- selectively activating elements of said array;
- detecting radiation received in respective ones of said detector elements; and
- calibrating said lithographic projection apparatus with reference to the results of said step of detecting.

7. A method according to claim 6 wherein in said step of selectively activating elements of said array, said elements are activated so that during a measurement interval only one of a plurality of elements of said array corresponding to a given one of said detector elements is activated.

8. A method according to claim 7 wherein said steps of selectively activating and detecting are repeated with a different one of said plurality of elements of said array corresponding to a given one of said detector elements being activated.

9. A method according to claim 6 wherein in said step of selectively activating elements of said array, said elements are activated so that during a first measurement interval a first set of a plurality of elements of said array corresponding to a given one of said detector elements is activated.

10. A method according to claim 9 wherein said steps of selectively activating and detecting are repeated with a different set of said plurality of elements of said array corresponding to a given one of said detector elements being activated.

11. A method according to claim 8 or 9 wherein said detector is moved relative to the projected patterned beam between repeats of said steps of selectively activating and detecting.

12. A device manufacturing method comprising the steps of:
- providing a substrate;
- providing a projection beam of radiation using an illumination system;
- an array of individually controllable elements to impart a pattern to the projection beam; and
- projecting the patterned beam of radiation onto a target portion of the substrate;
**characterized in that** prior to said step of using array of individually controllable elements, said array is calibrated by a method according to any one of claims 6 to 11.
